**Europäisches Patentamt**

**European Patent Office**

**Office européen des brevets**

(19)

(11) Numéro de publication : **0 478 426 A1**

(12)

# DEMANDE DE BREVET EUROPEEN

(21) Numéro de dépôt : **91402507.7**

(22) Date de dépôt : **20.09.91**

(51) Int. Cl.⁵ : **H01L 21/48,** H01L 25/065, H01L 23/13

(30) Priorité : **28.09.90 FR 9011988**

(43) Date de publication de la demande :
**01.04.92 Bulletin 92/14**

(84) Etats contractants désignés :
**DE GB IT**

(71) Demandeur : **THOMSON-CSF**
**51, Esplanade du Général de Gaulle**
**F-92800 Puteaux (FR)**

(72) Inventeur : **Bureau, Jean-Marc**
**THOMSON-CSF, SCPI, Cédex 67**
**F-92045 Paris la Défense (FR)**
Inventeur : **Graciet, Michel**
**THOMSON-CSF, SCPI, Cédex 67**
**F-92045 Paris la Défense (FR)**

(74) Mandataire : **Taboureau, James et al**
**THOMSON-CSF SCPI**
**F-92045 Paris La Défense Cédex 67 (FR)**

(54) **Procédé de réalisation d'un module hybride.**

(57)    L'invention concerne les modules hybrides dans lesquels une pluralité de puces de circuits intégrés (20) sont logées dans des alvéoles (18) creusées dans une tranche de silicium (10).
    Selon ce procédé, un réseau d'interconnexions (13) des puces (20) est d'abord réalisé sur une face du substrat (10) : il comprend au moins une couche de polymère. Puis les alvéoles (18) sont gravées à partir de l'autre face du substrat (10), jusqu'à rencontrer le réseau d'interconnexions (13). Les puces sont disposées dans les alvéoles (18) et interconnectées (26).

# FIG. 9

La présente invention concerne les systèmes hybrides d'assemblage et d'interconnexion d'une pluralité de puces de circuits intégrés sur un même substrat, de préférence en silicium. Plus précisément, elle concerne le procédé d'insertion des puces dans les alvéoles creusées dans un substrat et de raccordement de ces puces au réseau d'interconnexion. Les modules hybrides multipuces obtenus appartiennent au domaine de l'invention.

L'assemblage dans un module hybride de circuits intégrés modernes, présentant un nombre d'entrées-sorties de plus en plus élevé et fonctionnant à des cadences de plus en plus rapides, se heurte aujourd'hui aux limitations en densité et en performances électriques des techniques classiques de connexions de ces circuits. Les connexions les plus denses et les plus performantes seraient celles effectuées entre circuits fabriqués sur la même tranche de Silicium et réalisées à l'aide des mêmes technologies monolithiques telle que photolithographie ou dépôts en couches minces. Ce concept d'intégration dite "pleine tranche" se heurte malheureusement à des rendements déplorables et des côuts prohibitifs.

La tendance actuelle est de rassembler plusieurs circuits nus préalablement testés, de les disposer, généralement par collage, sur un même substrat plan et uni possédant déjà un système d'interconnexion et des les interconnecter directement sur le substrat.

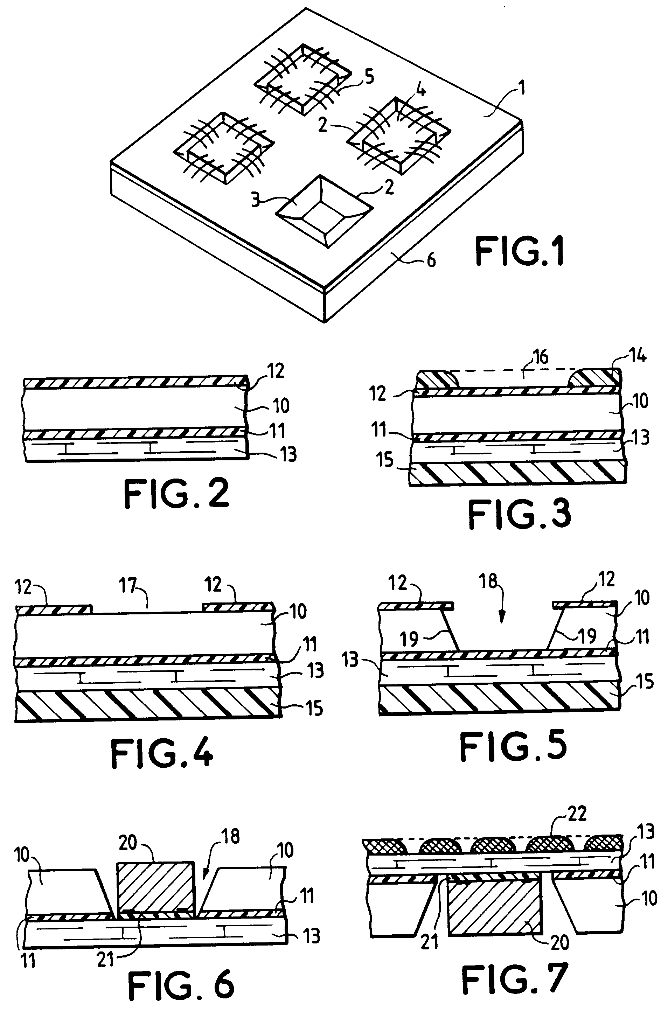

Une autre technique connue consiste à loger les puces dans des alvéoles creusées dans un substrat, tel que représenté en figure 1. Dans une tranche entière de silicium 1 sont creusées, par toutes techniques connues de l'homme de l'art, une pluralité d'alvéoles 2. Ces alvéoles ne sont pas aussi profondes que l'épaisseur de la tranche 1, et, en raison des plans cristallographiques d'un monocristal de silicium, les parois 3 des alvéoles 2 son inclinées. Chaque alvéole est donc plus grande que la puce de circuit intégré 4 qui est fixée, et, sur le plan supérieur de la tranche 1, il existe un vide entre le bord de l'alvéole 2 et le bord de la puce 4. Les puces 4 sont interconnectées par des moyens 5 sur lesquels on reviendra, et, le plus souvent, la tranche 1 est collée ou brasée sur une embase, radiateur ou boîtier 6, et bien évidemment le module est muni de connexions extérieures non représentées içi.

Il est avantageux d'utiliser le silicium comme substrat porteur des circuits car il permet d'utiliser les techniques connues des circuits intégrés pour réaliser un système d'interconnexion de haute densité. Il permet également d'adapter les coefficients de dilatation du substrat et des circuits par intégration silicium sur silicium. Un système multicouche est nécessaire pour répondre au besoin de densité et de performances des interconnexions. Peur bâtir ce système multicouche au moyen de matériaux diélectriques utilisables pour l'isolation des différentes couches conductrices, les polymères thermostables tels que polyimides, polyphénylquinoxalines .... sont préférés, en raison d'une part de leurs possibilités de mise en oeuvre (dépôt, ouverture de vias, planarisation) notamment pour des épaisseurs allant de quelques dixièmes à quelques dizaines de microns, et d'autre part, de leur faible permittivité, comparativement aux diélectriques minéraux, qui autorise une plus grande densité et qui permet de repousser les limites en fréquences du fonctionnement des dispositifs. L'utilisation d'interconnexions hybrides multicouches minces polymère-métal sur différents types de substrats est aujourd'hui bien connue.

Les interconnexions classiques circuits-substrat du type câblage filaire, tels que les fils 5 représentées en figure 1, sont aujourd'hui un facteur important limitant la densité, mais aussi le rendement de fabrication, les performances et la fiabilité d'un module hybride. Les techniques a priori plus favorables à la densification comme le montage d'une puce à l'envers, connu sous le nom "flip-chip" imposent d'autres contraintes telles que des problèmes de dissipation thermique et de disponibilité de circuits spécifiques.

Quelques techniques d'interconnexions collectives conduisant à un haut degré de densité et de performances sont connues. Ces techniques consistent à planariser la surface du module substrat-circuits et à déposer les interconnexions à la surface de celui-ci par un procédé de type circuit intégré.

Une de ces techniques consiste à laminer un film de Kapton à la surface d'un assemblage de plusieurs composants placés côte à côte, à ouvrir des vias dans ce film et à réaliser les interconnexions à la surface de ce film par dépôt de couches minces. Cette technique a cependant l'inconvénient de mettre en oeuvre une technologie particulière de laminage du film, difficile à maîtriser. Elle nécessite l'utilisation d'un film d'épaisseur importante et la planarisation ainsi obtenue n'est pas optimale pour autoriser une haute densité d'interconnexions.

Une autre de ces techniques consiste à insérer les circuits dans des alvéoles ouvertes dans un substrat de silicium, à aligner les surfaces des circuits et du substrat dans un même plan de référence et à fixer ces circuits au moyen d'un dépôt de résine à leur périphérie. La surface est alors planarisée par un dépôt de polymère et les interconnexions réalisées par dépôts de couches minces. Cette technique a également l'inconvénient d'être difficile à mettre en oeuvre (dépôt de la résine) et, du fait de cette résine, d'imposer d'importantes contraintes mécaniques au système.

Toutes ces techniques ont différents points communs. Dans le procédé, ce sont d'abord les alvéoles 2 qui sont creusées dans le substrat 1, puis les puces de circuits intégrés 4 sont fixées, et le réseau d'interconnexion 5 est réalisé par dessus l'ouverture des alvéoles, sur des puces qui ne sont pas toujours dans le plan de la face supérieure du substrat 1.

Dans le produit, les puces sont fixées par leur périphérie ou par leur face arrière sur le fond d'une alvéole.

Le procédé selon l'invention n'utilise que des techniques classiques de la microélectronique, faciles à mettre en oeuvre et bien contrôlables. Il présente également l'avantage de favoriser une excellente planarisation de la surface du module et donc de se prêter à la réalisation d'interconnexions de grande densité. Il permet la mise en oeuvre du polymère par dépôt à la tournette d'une solution et ainsi l'obtention d'une épaisseur choisie dans une large gamme, de quelques dixièmes à quelques dizaines de microns. Il autorise le choix parmi une large gamme de polymères disponibles en solution, et l'optimisation des propriétés de la couche déposée telle que par exemple des polyimides photosensibles, polymères à faibles contraintes mécaniques, à faible constante diélectrique.

Selon ce procédé, et au contraire de ce qui se faisait précédemment, le circuit d'interconnexion est d'abord réalisé sur une première face plane d'un substrat, puis des alvéoles sont creusées, sur toute l'épaisseur du substrat, à partir de la deuxième face de ce substrat, jusqu'à buter sur le circuit d'interconnexion, et enfin les puces de circuits intégrés sont introduites dans les alvéoles et réunies au circuit d'interconnexion.

Le module obtenu par le procédé selon l'invention se caractérise par le fait que son circuit d'interconnexion parfaitement plan se situe du côté du fond des alvéoles, et que l'espacement entre bords de puces et bords d'alvéoles se situe du côté de la face arrière de chaque puce, puisque les alvéoles sont ouvertes par la face arrière du substrat du module hybride multipuce.

De façon plus précise, l'invention concerne un procédé de réalisation d'un module hybride comportant une pluralité de puces de circuits intégrés disposées dans des alvéoles creusées dans un substrat supportant un circuit d'interconnexion des puces entre elles, ce procédé étant caractérisé en ce que l'étape de réalisation du circuit d'interconnexion sur une première face plane du substrat intervient avant l'étape de gravure des alvéoles dans le substrat par la deuxième face dudit substrat.

L'invention sera mieux comprise par la description plus détaillée d'un exemple d'application, en liaison avec les figures jointes en annexes qui représentent :

– figure 1 : module hybride multipuce selon l'art connu ;

– figures 2 à 5 : différentes étapes du procédé selon l'invention communes aux deux variantes de montage des puces ;

– figures 6 à 9 : étapes du procédé selon l'invention pour monter des puces interconnectées par ponts métalliques ;

– figure 10 : montage d'une puce en "flip-chip", et réseau d'interconnexion correspondant ;

– figure 11 : moyens d'interconnexion en trois dimensions ;

– figure 12 : vue en coupe d'un module hybride multipuces selon l'invention ;

– figure 13 : vue en coupe d'un module en trois dimensions selon l'invention.

La première étape du procédé est importante car elle consiste à réaliser un substrat pour le module multipuces, ayant déjà un circuit d'interconnexion. Les étapes suivantes consisteront à inclure les puces dans ce substrat et à les relier au circuit d'interconnexion.

Ce substrat doit assurer la rigidité mécanique du module et servir de support à la fabrication du système d'interconnexion. Il doit être compatible avec les opérations de type circuit intégré monolithique permettant de réaliser des interconnexions de haute densité et avec un bon rendement. De façon préférentielle il s'agit donc de substrats du type plaques circulaires de silicium monocristallin ou de silice.

En figure 2, une tranche de silicium 10, d'orientation [100] est utilisée comme substrat. Sur les deux faces principales de cette tranche 10, deux couches 11 et 12 de 2,5 à 3 $\mu$m de silice thermique sont formées à 1150°C dans un four d'oxydation. La couche 12 servira ultérieurement de masque de gravure, et la couche 11 servira de couche d'arrêt de gravure.

Sur la première face de la tranche de silicium 1, dite face supérieure, est alors réalisé le système d'interconnexion 13 entre les puces de circuits intégrés du futur module multipuce. Sur la figure 2, qui est représentée à l'envers pour une présentation homogène avec les figures suivantes, le système d'interconnexion est un circuit multicouches : il comporte au moins un niveau de métallisation et un niveau de polymère. De façon préférentielle, c'est un multicouches réalisé par les technologies classiques des semiconducteurs : enduction de résines, microlithographie et dépôts métalliques. A titre indicatif ce peut être un système multicouches constitué de deux couches métalliques (signaux X et Y) isolées par un diélectrique minéral (silice) ou organique (polymère thermostable). Ce système doit comprendre au moins une couche de polymère permettant sa tenue mécanique et la fixation des circuits après gravure des alvéoles. Ce niveau de polymère peut être un niveau d'isolation intermétallique ou un niveau déposé en dernier lieu.

Selon le type des circuits à connecter sur le module multipuces, deux possibilités sont offertes pour la réalisation du système d'interconnexion 13.

Pour les circuits classiques, normalement connectés par fils ou rubans métalliques soudés sur la puce, le système d'interconnexion 13 à la surface du substrat 10 ne comporte alors pas les métallisations correspondant aux connexions circuit-substrat. Celles-ci ne sont réalisées qu'après fixation mécanique de la face supérieure du circuit sur la face inférieure du système d'interconnexion, à l'aide d'un adhésif, par ouverture collective de trous à travers le polymère et dépôt de métal par photolithographie, comme cela sera expose ultérieurement.

Pour les circuits montés à l'envers, et connectés par des microbilles de soudure, c'est-à-dire de type "flip-chip", la totalité du système d'interconnexion du circuit est réalisée à la surface du substrat, y compris la disposition des plots de connexions, tels que ceux-ci devront déboucher dans l'alvéole ouverte. Ces plots peuvent éventuellement être protégés de la gravure du silicium et n'être dégagés qu'en dernier lieu par gravure sélective. Les circuits pourront alors être connectés par la technique du "flip-chip" sur la face inférieure du réseau d'interconnexion débouchant dans l'alvéole. Cette méthode, si elle est permise par la disponibilité des circuits, est avantageuse pour la simplicité de réalisation et pour le bon positionnement des circuits qu'autorise le "flip- chip".

La résine polymère utilisée pour la réalisation du circuit d'interconnexion 13 doit être compatible avec les techniques de fabrication du module et avec ses conditions de fonctionnement. De façon préférentielle, il s'agit d'un polymère thermostable que l'on peut mettre en oeuvre en couche mince par centrifugation d'une solution ou d'un précurseur, lui-même en solution ou liquide. A titre d'exemple, on peut citer les polyimides, les polyphénylquinoxalines, les polybenzocyclobutènes, certains fluoropolymères.

Selon les applications, la technologie choisie ou les performances attendues, on peut choisir ce polymère parmi une large gamme de produits disponibles commercialement. Ainsi, si la résolution désirable le permet, on peut utiliser un polyimide photosensible qui permet de réduire avantageusement le nombre des étapes technologiques (définition de motifs, ouverture de vias ... ). On peut aussi utiliser, pour optimiser des problèmes de contraintes mécaniques, un polyimide ayant un coefficient de dilatation thermique proche de celui du silicium. Si on désire un diélectrique de faible constante diélectrique, on peut choisir un polymère fluoré.

Sur les deux faces extérieures de l'objet composite représenté en figure 2 sont alors déposées deux couches 14 et 15 de résine de masquage photolithographique "négative". La couche 15, déposée sur le circuit d'interconnexion 13, sert à le protéger au cours des opérations de gravure des alvéoles.

De façon à simplifier l'exposé de l'invention, les figures 3 à 11 et le texte correspondant ne prennent en compte qu'une seule alvéole. Il est bien entendu que pour réaliser un module hybride multipuces, le procédé est collectif, et plusieurs alvéoles sont gravées simultanément.

Lesdites opérations commencent en figure 3, par la gravure de la couche de résine 14, déposée du côté de la deuxième face, dite inférieure, du substrat 10. L'insolation et le développement de la couche 14 dégage une fenêtre 16 qui, en figure 4, permet à son tour de graver un masque 17 dans la couche 12 de silice sous-jacente. Les fenêtres 16 et 17 correspondent :

- en dimensions, à celles de l'alvéole à graver donc à celles de la puce de circuit intégré à inclure dans le module ;
- en emplacement, au réseau d'interconnexion à établir ultérieurement avec le système 13.

Dans ce procédé, selon lequel le système d'interconnexion 13 est réalisé avant les alvéoles 18, celles-ci sont gravées dans toute l'épaisseur de ce substrat, à l'emplacement prévu pour l'insertion des circuits. Ainsi, le réseau d'interconnexion se retrouve suspendu au-dessus de l'alvéole, sa tenue mécanique étant assurée par la couche de polymère. Selon la nature du substrat choisi, plusieurs techniques de gravure des alvéoles sont possibles parmi les méthodes connues de gravure humide et de gravure sèche.

Ces techniques doivent répondre à des critères de rapidité, de contrôle dimensionnel des alvéoles et de compatilité avec l'intégrité du réseau d'interconnexions.

Afin d'optimiser ces critères, on peut utiliser avantageusement une combinaison de plusieurs techniques, et la disposition judicieuse de couches d'arrêt. A titre d'exemples non limitatifs, on peut citer quelques méthodes :

a) substrat de silicium :

- gravure chimique isotrope , par exemple par un mélange acide fluorhydrique/acide nitrique / acide acétique, ou anisotrope, c'est-à-dire permettant d'attaquer sélectivement selon certaines orientations cristallines, par exemple les plans [100] sont gravés beaucoup plus rapidement que les plans [111] dans des solutions à base d'hydroxydes de potassium, d'éthylénediamine ou d'hydrazine ;
- gravure sèche par plasma ou gravure ionique réactive, par $CF_4$ ou $SF_6$ par exemple.

De façon préférentielle, sur un substrat de silicium monocristallin, on choisit une gravure chimique anisotrope de type KOH car elle permet un bon contrôle dimensionnel des alvéoles et la formation de flancs obliques favorables au positionnement ultérieur des circuits. Cette gravure peut s'effectuer à travers un masque de résine, de silice, de nitrure de silicium, de métal ou de tout matériau déposé sur la face arrière du silicium et résistant à la gravure. De même, pour bloquer la gravure au fond des alvéoles afin de préserver la couche d'interconnexion et s'affranchir des problèmes de contrôle précis de la fin d'attaque et d'homogénéité, on peut avantageusement interposer entre cette couche et le silicium une couche de matériau résistant à la gravure et déposé sur toute la surface du silicium ou localisé à l'emplacement des alvéoles. Cette couche d'arrêt peut être composée d'un des matériaux déjà cités pour le masquage ou bien d'une membrane de silicium fortement dopée $P^+$ et localisée sur le substrat par exemple par implantation ionique ou diffusion dans le substrat.

    b) substrat de silice

       – gravure humide de type acide fluorhydrique,

       – gravure sèche de type plasma ou gravure ionique réactive par $CF_4$ ou de $CHF_3$.

Par exemple, en figure 5, on grave chimiquement à travers le masque de silice, le substrat de silicium 10 dans une solution diluée de KOH à 90°C ; on obtient alors une gravure anisotrope 18 du silicium préférentielle dans la direction <100> avec formation de flancs obliques 19 correspondant aux plans [111] et formant une intersection à 54°74 avec les plans [100], les lignes d'intersection correspondant aux directions <110>. La couche de silice 11 de la face dite supérieure sert de couche d'arrêt, elle protège les couches d'interconnexion 13 des agents chimiques de la gravure et permet de s'affranchir des problèmes de détection précise de fin d'attaque et d'homogénéité de vitesse de gravure sur l'ensemble des alvéoles.

La silice du masque de gravure 12 et de la couche d'arrêt 11 dans le fond de l'alvéole 18 est éliminée par gravure ionique réactive dans un plasma de $CHF_3$. Cette gravure s'arrête sélectivement quand le polyimide du fond des alvéoles 18 est dégagé.

La couche de résine 15 de protection sur la face dite supérieure est éliminée par dissolution sélective.

Le produit obtenu est, à ce point du procédé, un substrat 10, supportant un circuit d'interconnexion 13 et gravé sur toute son épaisseur par une alvéole 18. Le fond de l'alvéole est dégagé de la silice 11 qui sépare le substrat 10 et le multicouches 13.

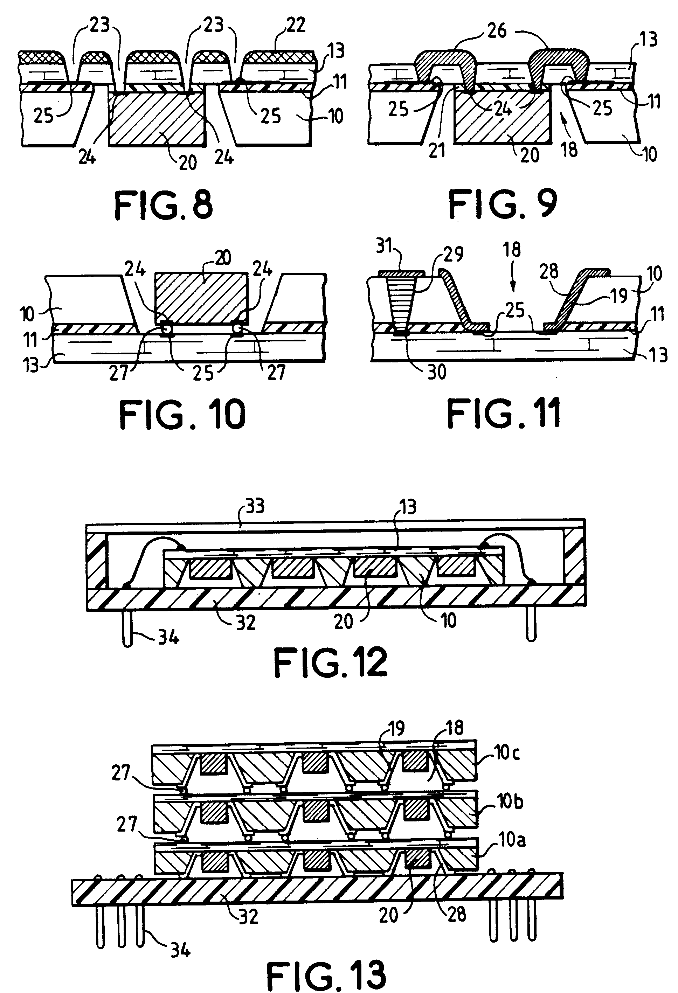

Les étapes suivantes présentent des variantes selon le type de puce de circuit intégré utilisé : les figures 6 à 9 sont relatives à des circuits intégrés en puces normales, et la figure 10 est relative à des circuits intégrés en puces munies de billes de soudure, ou "flip-chip".

Après gravure des alvéoles 18, les circuits prétestés sont insérés dans celles-ci, leur face active étant fixée contre la face interne du réseau d'interconnexion, débouchant dans l'alvéole.

Dans le cas des circuits standard, ceux-ci sont fixés mécaniquement sous le réseau d'interconnexion par le moyen d'un film adhésif et la connexion électrique du circuit au réseau se fait par la face externe de ce dernier à l'aide des techniques classiques de photolithographie, gravure, dépôt métallique sous vide.

En figure 6, une puce 20 de circuit intégré est insérée dans une alvéole 18 au fond de laquelle il est maintenu par une couche 21 d'adhésif déposée en solution. La puce 20 y est placée avec sa face active contre la face interne du réseau d'interconnexion 13.

Un dispositif optique, non représenté, placé sous le substrat permet le positionnement précis des circuits 20 par rapport au réseau d'interconnexion 1.3. On dépose alors, en figure 7, une résine de photolithographie positive 22 qui; isolée et développée, sert de masque, figure 8, à la gravure ionique réactive du polyimide dans un plasma de $CF_4$ et $O_2$ pour la formation des trous d'interconnexion 23 qui débouchent sur les plots d'entrée - sortie 24 des circuits intégrés et sur les plots de reprise de contact 25 du réseau d'interconnexion. Ces plots sont ensuite reliés électriquement deux à deux par métallisations de cuivre 26, montrées en figure 9.

Dans le cas de la connexion de type "flip-chip, en figure 10, le circuit 20 est équipé de bossages 27 que l'on refond au contact des plots de connexion 25 du réseau 13, après alignement de l'un par rapport à l'autre. Chaque puce 20 est fixée par ses plots de connexion 27 : il n'y a pas d'adhésif 21.

Dans les deux cas, le procédé se prête particulièrement à une optimisation du positionnement des circuits par rapport au réseau d'interconnexion. La transparence dans le visible du réseau d'interconnexion au niveau des alvéoles permet d'utiliser une méthode optique simple pour positionner les plots de connexions 24 du circuit par rapport aux plots correspondants 25 du réseau.

De plus, dans le cas d'un substrat silicium monocristallin, l'utilisation d'une technique de gravure chimique anisotrope permet d'obtenir des alvéoles présentant des plans cristallins obliques bien définis pouvant être utilisés ou un positionnement efficace des circuits. C'est ainsi que les puces 20 de circuits intégrés sont positionnées par les bords 19 des alvéoles 18 avec une précision de 25 micromètres.

Enfin, l'utilisation du procédé "flip-chip", permet d'optimiser encore ce positionnement par l'effet d'autocentrage dû aux tensions superficielles lors de la refusion des bossages. Le procédé "flip-chip" se prête également à la réparabilité : remplacement d'un circuit défaillant par chauffage local et dessoudage des bossages.

La figure 11 montre deux exemples de contacts transversaux par rapport au substrat, permettant une interconnexion en trois dimensions.

Après gravure des alvéoles 18 il est possible, par gravure sélective de la couche d'arrêt 11 et/ou des couches diélectriques 13 de faire déboucher des métallisations 25 correspondant à des signaux, des alimentations ou des masses qu'il est avantageux de faire traverser directement le module sans passer par sa périphérie, par exemple pour connexion à un autre substrat ou à un module adjacent en assemblage à trois dimensions. Dans ce cas, la métallisation peut être reprise et transférée sur la face inférieure du substrat en passant par le flanc de l'alvéole. En particulier, dans le cas d'alvéoles obtenues par gravure anisotrope et présentant des flancs obliques 19, il est possible de réaliser sur ces flancs des métallisations 28 par dépôts de couches minces et photolithographie à l'aide d'un laser piloté par ordinateur pouvant être focalisé le long du flanc 19 de l'alvéole 18.

Une autre possibilité consiste à réaliser à travers le substrat 10 un trou métallisé 29 qui met en communication deux métallisations 30 et 31, situées sur deux faces opposées du substrat 10 : c'est la technique connue sous le nom "via hole".

Le module ainsi réalisé doit être connecté avec l'extérieur, équipé d'un dispositif de refroidissement permettant d'évacuer les calories émises par les composants dissipatifs et enfin protégé de l'environnement. Un premier exemple en est donné en figure 12.

Le module hybride est collé par la face arrière de la tranche 10, c'est-à-dire celle qui ne porte pas le réseau d'interconnexion 13 sur un substrat céramique 38 en Al$_2$O$_3$, AlN SiC... ou métallique. Ce substrat 32 servant au transfert thermique, les circuits 20 ont l'avantage d'être en contact direct avec le conducteur thermique. Ce substrat 32 supporte le réseau d'interconnexion du module avec l'extérieur : broches 34 sous le substrat ou plots en périphérie dans le cas de la connectique dite "fond de panier". Ce substrat peut également supporter des interconnexions internes ou des niveaux d'alimentation et de masse. Le module est connecté au substrat par la périphérie du module par soudage classique de connexions, par des trous conducteurs traversant le module ou par des métallisations face avant - face arrière dont le dépôt sur les faces obliques des alvéoles est possible dans le cas de cette invention.

Ce substrat sert enfin au support d'un boîtier hermétique 33.

Plusieurs de ces modules peuvent également être interconnectés entre eux dans une configuration à trois dimensions schématisée en figure 13. Dans ce cas, face supérieure et face inférieure de chaque module 10a, 10b, 10c sont reliées par des trous conducteurs ou des métallisations 28 sur les flancs obliques 19 des alvéoles 18, et des plots de contact sont réalisés sur chacune des faces. Les modules peuvent alors être assemblés à l'aide de bossages 27 reliant deux plots en vis-à-vis.

Un tel empilement à trois dimensions peut être refroidi par circulation forcée d'un fluide caloporteur air ou fluorinert, dans les interstices laissés entre les plans des modules. Il est également, comme celui de la figure précédente, fixé sur un substrat 32 muni d'une connectique 34 et protégé par un boîtier qui n'est pas ici représenté.

Cette invention permet une minimisation des contraintes mécaniques du système, par compensation des contraintes produites par le substrat alvéolé et des contraintes apportées par la couche du polymère. Cette compensation peut en particulier être ajustée par le choix du polymère, son épaisseur et ses conditions de dépôt.

Un autre avantage de cette invention, est qu'elle facilite le positionnement des circuits par rapport au substrat. En effet, au cours de l'opération de soudure des puces sur le circuit d'interconnexion, celles- ci s'autopositionnent par les forces capillaires dans les plages de soudure fondue.

Cette invention permet la réalisation de connexions électriques entre les faces supérieure et inférieure du module, elle se prête donc implicitement à des structures à trois dimensions, complément logique de l'intégration en deux dimensions de puces sur un substrat alvéolé.

**Revendications**

1. Procédé de réalisation d'un module hybride comportant une pluralité de puces (20) de circuits intégrés disposés dans des alvéoles (18) creusées dans un substrat (10) supportant un circuit d'interconnexion (13) des puces entre elles, ce procédé étant caractérisé en ce que l'étape de réalisation du circuit d'interconnexion (13) sur une première face plane du substrat (10) intervient avant l'étape de gravure des alvéoles (18) dans le substrat, par la deuxième face dudit substrat.

2. Procédé de réalisation d'un module hybride selon la revendication 1, caractérisé en ce que le circuit d'interconnexion (13) comprend au moins une couche de polymère et une couche métallique.

3. Procédé selon la revendication 1, caractérisé par l'existence d'une couche de silice (11) entre le substrat (10) et le circuit d'interconnexion (13).

4. Procédé selon la revendication 1, caractérisé en ce que le substrat (10) est une tranche de matériau semiconducteur particulièrement le silicium monocristallin.

5. Procédé selon la revendication 1, caractérisé en ce qu'il comporte les étapes suivantes :
   a) sur chacune des deux faces principales d'une tranche de silicium monocristallin utilisée comme substrat (10), dépôt d'une couche de silice (11, 12), et réalisation d'un circuit d'interconnexion (13) comportant au moins une couche de polymère, sur la première face principale du substrat (10),
   b) sur chacune des deux faces principales du produit obtenu, dépôt d'une couche de résine de masquage (14, 15), la couche (15) déposée sur la circuit d'interconnexion (13) servant de protection,

c) par la deuxième face principale, exposition et développement de la résine de masquage (14), aux emplacements (16) correspondant aux futures alvéoles (18), gravure dans la deuxième couche de silice (12) du masque (17) correspondent, élimination de la résine (14) restante gravure dans le substrat (10) des alvéoles (18) puis élimination de la silice de la couche d'arrêt (11) dans le fond des alvéoles (18) et de la silice de la couche de masquage (12) autour' des alvéoles,

d) fixation d'une puce de circuit intégré (20) dans chacune des alvéoles (18) et raccordement de chaque puce au' circuit d'interconnexion ( 13) en fonction de la technologie utilisée pour les plots de raccordement (24) de chaque puce (20).

6. Procédé selon la revendication 5, caractérisé en ce que, dans le cas où une puce de circuit intégré (20) est munie de plots de raccordement (24) plats, son raccordement au circuit d'interconnexion ( 13 ) comprend les étapes suivantes :

a) au moyen d'une couche d'adhésif (21), collage de la puce (20), dans chaque alvéole (18), par la face active contre le circuit d'interconnexion ( 13),

b) sur la face externe du circuit d'interconnexion (13), dépôt d'une couche de résine de masquage (22), exposition et développement en vue de créer des puits (23) à l'aplomb des plots de raccordements (24) sur la puce (20) et de ceux (25) du circuit d'interconnexion (13) qui sont disposés sur un périmètre externe au contour de l'alvéole (18),

c) réalisation de ponts métalliques (26) entre les dits plots de raccordement (24, 25).

7. Procédé selon la revendication 5, caractérisé en ce que, dans le cas où une puce de circuit intégré (20) est munie de plots de raccordements (24) à bossages ou équipés d'une bille de soudure (27), son raccordement au circuit d'interconnexion (13) se fait par soudure directe des billes (27) sur les plots de raccordements (25) du circuit d'interconnexion (14), qui sont disposés sur un périmètre interne au contour de l'alvéole (18).

8. Procédé selon la revendication 5, caractérisé en ce qu'il comprend en outre la réalisation d'interconnexions entre les deux faces du module au moyen de métallisations (28) déposées sur les flancs (19) des alvéoles (18).

9. Procédé selon la revendication 5, caractérisé en ce qu'il comprend en outre la réalisation d'interconnexions entre les deux faces du module au moyen de trous métallisés (29) à travers l'épaisseur du substrat ( 10).

10. Module hybride comportant une pluralité de puces de circuits intégrés (20) disposés dans des alvéoles (18) creusées dans un substrat (10) supportant un circuit d'interconnexion (13) des puces ( 20) entre elles, ce module étant caractérisé en ce que le circuit d'interconnexion (13) comporte au moins une couche de polymère.

11. Module selon la revendication 10, caractérisé par l'existence d'une couche de silice (11) entre le substrat (10) et le circuit d'interconnexion (13).

FIG.1

FIG. 2

FIG. 3

FIG.4

FIG. 5

FIG. 6

FIG. 7

FIG. 8

FIG. 9

FIG. 10

FIG. 11

FIG. 12

FIG. 13

**Office européen des brevets**

# RAPPORT DE RECHERCHE EUROPEENNE

Numero de la demande

EP    91 40 2507

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | GB-A-2 202 673 (AHMED-HOPPER) <br> * page 11, ligne 6 - ligne 10; revendications 1-3,6 * | 1 | H01L21/48 <br> H01L25/065 <br> H01L23/13 |
| A | | 3-6,10, 11 | |
| | --- | | |
| X | FR-A-2 634 322 (THOMSON) <br> * page 8, ligne 6 - ligne 17; revendication 1 * <br> * page 21, ligne 8 - ligne 11 * | 10 | |
| A | | 1,2,4,5, 7 | |
| | --- | | |
| A | EP-A-0 222 144 (FUJITSU) | | |
| | --- | | |
| A | IEEE TRANSACTIONS ON COMPONENTS, HYBRIDS AND MANUFACTURING TECHNOLOGY <br> vol. 12, no. 2, Juin 1989, NEW YORK, US <br> pages 185 - 194; <br> R.W. JOHNSON ET AL.: 'Multichip thin-film technology on silicon' <br> * le document en entier * | 8 | |
| | --- | | **DOMAINES TECHNIQUES RECHERCHES (Int. Cl.5)** |
| A | GB-A-2 026 234 (MITSUMI) <br> * abrégé * | 8 | H01L |
| | --- | | |
| A | IBM TECHNICAL DISCLOSURE BULLETIN. <br> vol. 21, no. 6, Novembre 1978, NEW YORK US <br> pages 2318 - 2319; <br> B.T. CLARK ET AL.: 'Integrated seal and signal band for stacked modules' <br> * le document en entier * | 9 | |
| | ----- | | |

Le présent rapport a été établi pour toutes les revendications

| Lieu de la recherche | Date d'achèvement de la recherche | Examinateur |
|---|---|---|
| LA HAYE | 21 NOVEMBRE 1991 | DE RAEVE R.A.L. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

................................................................

& : membre de la même famille, document correspondant

EPO FORM 1503 03.82 (P0402)